# EUROPÄISCHE PATENTSCHRIFT

(11) **EP 1 061 649 B1**
(45) Veröffentlichungstag und Bekanntmachung des Hinweises auf die Patenterteilung: **19.10.2005**
(21) Anmeldenummer: 00111929.6
(22) Anmeldetag: 15.06.2000
(51) Int. Cl.: H03K 17/16, H03K 3/012, H03K 7/08

(54) **Schaltungsanordnung und Verfahren zur Steuerung einer Last**
Circuit arrangement and method for controlling a load
Circuit et procédé pour la commande d'une charge

(30) Priorität: 17.06.1999 DE 19927565; 24.06.1999 DE 19928907
(43) Veröffentlichungstag der Anmeldung: 20.12.2000
(73) Patentinhaber: Alcoa Fujikura Gesellschaft mit beschränkter Haftung, 72636 Frickenhausen (DE)
(72) Erfinder: Flock, Horst, 72766 Reutlingen (DE); Fortmeier, Ignaz, 67067 Ludwigshafen (DE)
(74) Vertreter: Hoeger, Stellrecht & Partner Patentanwälte

(56) Entgegenhaltungen:
- EP-A- 0 088 277
- DE-A- 2 610 432

## Beschreibung

Die Erfindung betrifft eine Steuerschaltung zum leistungsgesteuerten Betreiben einer Last, umfassend einen in einem Laststromkreis wirksamen Halbleiterschalter, welcher zur Leistungssteuerung der Last eine Speisespannung pulsweitenmoduliert, und eine Ansteuerung für den Halbleiterschalter, welche zur Leistungssteuerung sowohl in einem unteren Teillastbereich als auch in einem zwischen dem unteren Teillastbereich und Vollast liegenden oberen Teillastbereich ein Pulssteuersignal, umfassend aufeinanderfolgende und durch Pulspausen getrennte pulsweitenmodulierte Pulssteuersignale, erzeugt.

Eine derartige Steuerschaltung ist aus dem Stand der Technik, beispielsweise der EP 088 277 A2 bekannt. Diese Schaltung arbeitet als Pulswechselrichter für Asynchronmotoren.

Bei einer Steuerschaltung, deren Steuersignal Ansteuerpulse aufweist, die in einer definierten Frequenz aufeinanderfolgen und zum Steuern der Last pulsweitenmoduliert sind, führt das aufgrund der Ansteuerpulse erfolgende Aus- und Einschalten der Last, insbesondere bei einer induktiven Last mit Freilaufelement, d. h. beispielsweise Freilaufhalbleiterbauteil, zu erhöhten Verlusten und insbesondere einer verstärkten Wärmeerzeugung.

Der vorliegenden Erfindung liegt daher die Aufgabe zugrunde, eine Steuerschaltung der gattungsgemäßen Art derart zu verbessern, daß die Wärmeerzeugung möglichst gering ist.

Diese Aufgabe wird bei einer Steuerschaltung der eingangs beschriebenen Art erfindungsgemäß dadurch gelöst, daß die Ansteuerung über ein Eingangssignal Information darüber erhält, mit welcher Leistung die Last betrieben werden soll, daß die Ansteuerung differenziert, ob die Leistung mit der die Last betrieben werden soll, im unteren Teillastbereich oder im oberen Teillastbereich liegt, daß die Ansteuerung in dem oberen Teillastbereich als Pulssteuersignal ein erstes Pulssignal mit mit einer ersten Pulsfrequenz fortlaufend aufeinanderfolgenden ersten Einzelpulsen sowie in den Pulspausen des ersten Pulssignals ein zweites Pulssignal mit mit einer zweiten Frequenz fortlaufend aufeinanderfolgenden zweiten Einzelpulsen erzeugt, wobei die zweite Frequenz mindestens um einen Faktor 10 größer als die erste Frequenz ist und wobei in dem oberen Teillastbereich mindestens eines der ersten und zweiten Pulssignale zur Leistungssteuerung pulsweitenmodulierbar ist, und daß die Ansteuerung in dem unteren Teillastbereich als Pulssteuersignal ein drittes Pulssignal mit einer dritten Frequenz erzeugt, die größer als die erste Frequenz ist.

Der Kern der vorliegenden Erfindung ist somit darin zu sehen, einerseits die Last, d. h. beispielsweise einen als induktive Last wirkenden Motor, durch das erste Pulssignal mit niedriger Frequenz so anzusteuern, daß durch dieses Pulssignal möglichst viel Leistung bei möglichst wenig Ein- und Ausschaltvorgängen der Last zugeführt werden kann, andererseits aber in den durch die niedrige Frequenz des ersten Pulssignals bedingten langen Pausen zwischen den Einzelpulsen mit dem zweiten Pulssignal mit hoher Frequenz ebenfalls noch Leistung zuzuführen, um die Nachteile des ausschließlichen Betreibens der Last mit nur dem ersten Pulssignal mit niedriger Frequenz zu vermeiden, wobei sich diese Nachteile insbesondere in einer mechanischen Geräuschentwicklung oder dem Entstehen mechanischer Resonanzen zeigen.

Ferner ist dadurch, daß in einem unterhalb des oberen Teillastbereichs liegenden Teillastbereich das Steuersignal ein drittes Pulssignal mit einer dritten Frequenz umfaßt, die größer als die erste Frequenz ist, so daß die Einzelpulse des dritten Pulssignals in entsprechend geringen Zeitintervallen aufeinanderfolgen, eine einfache Art der Steuerung mit ausreichender Präzision realisierbar.

Hinsichtlich der Steuerung der Leistung, die der Last zugeführt werden soll, bestehen dabei die unterschiedlichsten Möglichkeiten. Eine Möglichkeit wäre die, die Frequenz des zweiten Pulssignals oder gegebenenfalls auch des ersten Pulssignals zu ändern.

Da vorzugsweise jedoch beim gepulsten Betrieb einer Last zur Vermeidung von peripheren Störungseinflüssen mit definierten feststehenden Frequenzen gearbeitet wird, ist vorzugsweise vorgesehen, daß in dem oberen Teillastbereich mindestens eines der ersten und zweiten Pulssignale zur Leistungssteuerung pulsweitenmodulierbar ist, d. h., daß über die Variation der Pulsweite bei feststehender Frequenz des jeweiligen Pulssignals die der Last zugeführte Leistung gesteuert werden kann.

Besonders günstig ist es bei der erfindungsgemäßen Lösung, wenn in dem oberen Teillastbereich beide Pulssignale pulsweitenmodulierbar sind, so daß durch inkrementelle Verstellung der Pulsweite beider Pulssignale die gewünschte Präzision der Steuerung durch die Einstellung der Pulsweite desjenigen Pulssignals erreicht werden kann, dessen Inkremente die kleineren sind. Vorzugsweise ist dies das zweite Pulssignal, wobei mit dem zweiten Pulssignal auch eine Zunahme der Pulsweite des ersten Pulssignals durch abnehmende Pulsweite des zweiten Pulssignals reduzierbar ist.

Bei einer besonders einfach arbeitenden Steuerschaltung ist vorzugsweise vorgesehen, daß im oberen Teillastbereich nur eines der Pulssignale pulsweitenmodulierbar ist.

In diesem Fall ist eine besonders präzise Leistungssteuerung dadurch durchführbar, daß der obere Teillastbereich in einen höchsten oberen Teillastbereich und einen normalen oberen Teillastbereich unterteilbar ist und daß in dem normalen oberen Teillastbereich die Einzelpulse des ersten Pulssignals pulsweitenmodulierbar sind und daß in dem höchsten oberen Teillastbereich die Einzelpulse des zweiten Pulssignals pulsweitenmodulierbar sind.

Insbesondere bei einer möglichst einfach arbeitenden Ausführungsform ist dabei vorgesehen, daß in dem normalen oberen Teillastbereich die Pulsweite der Einzelpulse des zweiten Pulssignals konstant ist und vorzugsweise in dem höchsten oberen Teillastbereich die Pulsweite der Einzelpulse des ersten Pulssignals konstant ist.

Beispielsweise wäre es denkbar, im Rahmen der erfindungsgemäßen Lösung, auch außerhalb des oberen Teillastbereichs mit einem Steuersignal zu arbeiten, das das erste Pulssignal und in den Pulspausen desselben das zweite Pulssignal zeigt.

Vorzugsweise sollte dabei die dritte Frequenz in derselben Größenordnung liegen wie die zweite Frequenz, so daß sowohl die zweite Frequenz als auch die dritte Frequenz deutlich über der ersten Frequenz liegen, um in dem unteren Teillastbereich eine möglichst geräuschfreie und resonanzfreie Ansteuerung der Last vornehmen zu können.

Eine aufgrund der Einfachheit besonders günstige Lösung sieht vor, daß die dritte Frequenz und die zweite Frequenz ungefähr gleich groß sind, so daß also sowohl im unteren

Teillastbereich als auch im oberen Teillastbereich die vorteilhaften Steuereigenschaften eines Pulssignals mit relativ hoher Pulsfrequenz ausgenützt werden können.

Eine besonders günstige Lösung sieht vor, daß die dritte Frequenz mit der zweiten Frequenz identisch ist, so daß letztlich sowohl zum Betreiben der Last im unteren Teillastbereich als auch zum Betreiben der Last im oberen Teillastbereich stets mit derselben Frequenz gearbeitet werden kann und beim Übergang vom unteren Teillastbereich zum oberen Teillastbereich lediglich das zweite Pulssignal hinzu kommt.

Zur Leistungssteuerung im unteren Teillastbereich ist dabei das dritte Pulssignal vorzugsweise ebenfalls pulsweitenmodulierbar.

Der Übergang von dem unteren Teillastbereich in den oberen Teillastbereich kann prinzipiell bei beliebigen Werten der Teillast liegen. Eine besonders vorteilhafte Lösung sieht vor, daß der Übergang von dem unteren Teillastbereich in den oberen Teillastbereich bei Teillastwerten zwischen ungefähr 20 % und ungefähr 50 %, jeweils bezogen auf Vollast, erfolgt.

Eine besonders günstige Lösung sieht vor, daß der Übergang von dem unteren Teillastbereich in den oberen Teillastbereich bei Teillastwerten von ungefähr 30 % bis ungefähr 40 % erfolgt.

Hinsichtlich der Unterschiede der zweiten Frequenz und der dritten Frequenz gegenüber der ersten Frequenz ist es - wie bereits ausgeführt - prinzipiell ausreichend, daß diese mindestens einen Faktor 10 betragen. Besonders günstig ist es jedoch, wenn die Frequenzunterschiede bei einem Faktor in der Größenordnung von 30 oder mehr, vorzugsweise in der Größenordnung von 100 oder mehr, liegen.

Prinzipiell wäre es möglich, in dem Teillastbereich unterhalb der vollen Ansteuerung der Last mit weiteren Teillastbereichen, beispielsweise auch zwischen dem unteren Teillastbereich und dem oberen Teillastbereich, zu arbeiten. Aus Gründen der Einfachheit hat es sich jedoch als günstig erwiesen, wenn der obere Teillastbereich sich unmittelbar an den unteren Teillastbereich anschließt.

Darüber hinaus wäre es noch denkbar, außerhalb des unteren und des oberen Teillastbereichs zusätzliche Teillastbereiche vorzusehen, in denen eine anders geartete Ansteuerung der Teillast erfolgen kann.

Besonders günstig ist es jedoch, wenn der untere Teillastbereich und der obere Teillastbereich den gesamten Teillastbereich bis zur Vollast abdecken.

Hinsichtlich der Erzeugung der Steuersignale im Fall einer erfindungsgemäßen Steuerschaltung wurden keine näheren Angaben gemacht, insbesondere keine näheren Angaben zum Aufbau der Ansteuerung. So sieht eine vorteilhafte Lösung vor, daß die Ansteuerung einen Pulsgenerator und eine Pulsformerstufe aufweist, wobei der Pulsgenerator insbesondere ein im wesentlichen Rechteckpulse erzeugender Pulsgenerator sein kann, und die Pulsformerstufe dann beispielsweise die Flanken der Rechteckpulse derart formt, daß ausreichend lange Steuerzeiten für den Betrieb der Last, insbesondere einer induktiven Last mit Freilaufdiode, zur Verfügung stehen.

Besonders günstig ist es dabei, wenn die Pulsformerstufe aus den Rechteckpulsen im wesentlichen in den Flanken zeitlich verzögerte Anstiegs- und Abfallzeiten erzeugt.

Beispielsweise lassen sich derartige zeitlich verzögerte Anstiegs- und Abfallzeiten durch RC-Glieder der Pulsformerstufe erzeugen.

Hinsichtlich der Erzeugung des ersten Pulssignals und des in den Pulspausen des ersten Pulssignals auftretenden zweiten Pulssignals wurden bislang keine näheren Angaben gemacht. So sieht eine vorteilhafte Ausführungsform vor, daß das erste Pulssignal und das zweite Pulssignal als fortlaufende Einzelpulse aufweisende Pulssignalzüge mit konstanter Frequenz erzeugbar sind und daß aus den Pulssignalzügen durch ODER-Verknüpfung das Steuersignal für den oberen Teillastbereich entsteht.

Eine derartige Erzeugung des Steuersignals kann auch dann beibehalten werden, wenn das Steuersignal für den unteren Teillastbereich erzeugt werden soll. In diesem Fall wird der Einfachheit halber die Pulsweite des ersten Pulssignals auf im wesentlichen 0 reduziert.

Darüber hinaus wird die eingangs genannte Aufgabe auch durch ein Verfahren zum leistungsgesteuerten Betreiben einer Last mittels einer Steuerschaltung, umfassend einen in einem Laststromkreis wirksamen Halbleiterschalter, welcher zur Leistungssteuerung der Last eine Speisespannung pulsweitenmoduliert, und eine Ansteuerung für den Halbleiterschalter, welche zur Leistungssteuerung sowohl in einem unteren Teillastbereich als auch in einem zwischen dem unteren Teillastbereich und Vollast liegenden oberen Teillastbereich ein Pulssteuersignal umfassend aufeinanderfolgende, durch Pulspausen getrennte pulsweitenmodulierte Pulssteuersignale erzeugt, erfindungsgemäß dadurch gelöst, daß die Ansteuerung über ein Eingangssignal darüber informiert wird, mit welcher Leistung die Last betrieben werden soll, daß von der Ansteuerung differenziert wird, ob die Leistung, mit der die Last betrieben werden soll, im unteren Teillastbereich oder im oberen Teillastbereich liegt, daß von der Ansteuerung in dem oberen Teillastbereich als Pulssteuersignal ein erstes Pulssignal mit mit einer ersten Pulsfrequenz fortlaufend aufeinanderfolgenden Einzelpulsen sowie in den Pulspausen des ersten Pulssignals ein zweites Pulssignal mit mit einer zweiten Pulsfrequenz fortlaufend aufeinanderfolgenden Einzelpulsen erzeugt wird, wobei die zweite Pulsfrequenz mindestens um einen Faktor 10 größer als die erste Pulsfrequenz ist und wobei die Leistungssteuerung durch Pulsweitenmodulation mindestens eines der ersten und zweiten Pulssignale durchgeführt wird, und daß von der Ansteuerung in dem unteren Teillastbereich ein Pulssteuersignal erzeugt wird, welches ein drittes Pulssignal mit einer dritten Frequenz umfaßt, die größer ist als die erste Frequenz.

Darüber hinaus ist es bei der Steuerung der Leistung außerhalb des oberen Teillastbereichs von Vorteil, wenn unterhalb des oberen Teillastbereichs ein Steuersignal erzeugt wird, welches ein drittes Pulssignal mit einer dritten Frequenz umfaßt, die größer ist als die erste Frequenz.

Besonders günstig ist es, wenn in dem oberen Teillastbereich die Leistungssteuerung durch Pulsweitenmodulation mindestens eines der ersten und zweiten Pulssignale durchgeführt wird, wobei vorzugsweise die Frequenz des ersten Pulssignals und des zweiten Pulssignals konstant gehalten wird.

Eine hinsichtlich der Variationsmöglichkeit besonders günstige Lösung sieht dabei vor, daß zur Leistungssteuerung die Pulsweite beider Pulssignale moduliert wird.

Aus Gründen der Einfachheit ist es jedoch günstig, wenn nur die Pulsweite eines der Pulssignale moduliert wird, während das andere der Pulssignale konstant gehalten wird.

Ferner ist es für eine besonders präzise Steuerung von Vorteil, wenn der obere Teillastbereich in einen höchsten oberen Teillastbereich und einen normalen oberen Teillastbereich aufgeteilt wird.

Vorzugsweise wird in dem normalen oberen Teillastbereich das erste Pulssignal hinsichtlich der Pulsweite zur Leistungssteuerung moduliert, während in dem höchsten oberen Teillastbereich das zweite Pulssignal zur Steuerung der Leistung moduliert wird.

Der Einfachheit halber bleibt das jeweils andere Pulssignal dabei hinsichtlich seiner Pulsweite konstant.

Vorzugsweise ist die dritte Frequenz ebenfalls so gewählt, daß sie in derselben Größenordnung wie die zweite Frequenz liegt.

Aus Gründen der Einfachheit ist es jedoch besonders günstig, wenn die dritte Frequenz mit der zweiten Frequenz identisch ist.

Ferner ist es zur Leistungssteuerung in dem unteren Teillastbereich ebenfalls von Vorteil, wenn das dritte Pulssignal hinsichtlich seiner Pulsweite moduliert wird, wobei insbesondere die Frequenz, mit welcher die Einzelpulse aufeinanderfolgen, beim dritten Pulssignal ebenfalls konstant gehalten wird.

Hinsichtlich der Lage des oberen Teillastbereichs und des unteren Teillastbereichs relativ zueinander wurden bislang ebenfalls keine spezifischen Angaben gemacht. Beispielsweise könnten der obere Teillastbereich und der untere Teillastbereich noch voneinander getrennt sein. Besonders günstig ist es jedoch, wenn der obere Teillastbereich unmittelbar an den unteren Teillastbereich anschließt.

Ferner ist vorzugsweise aus Gründen der Einfachheit vorgesehen, daß der untere Teillastbereich und der obere Teillastbereich den gesamten Teillastbereich bis zur Vollast abdecken.

Um bei dem erfindungsgemäßen Verfahren das Steuersignal möglichst einfach erzeugen zu können, ist vorzugsweise vorgesehen, daß das erste Pulssignal und zweite Pulssignal als fortlaufende Pulssignalzüge mit konstanter Frequenz erzeugt werden und durch ODER-Verknüpfung aus den beiden Pulssignalzügen das Steuersignal im oberen Teillastbereich erzeugt wird.

In gleicher Weise besteht auch die Möglichkeit, im unteren Teillastbereich das Steuersignal zu erzeugen, wobei die Pulsweite dabei im wesentlichen auf 0 gehalten wird.

Weitere Merkmale und Vorteile der Erfindung sind Gegenstand der nachfolgenden Beschreibung sowie der zeichnerischen Darstellung eines Ausführungsbeispiels. In der Zeichnung zeigen:
- Fig. 1: eine schematische Darstellung eines ersten Ausführungsbeispiels einer erfindungsgemäßen Steuerschaltung;
- Fig. 2: eine schematische Darstellung der Aufteilung des Teillastbereichs in einen unteren Teillastbereich und einen oberen Teillastbereich;
- Fig. 3: eine schematische Darstellung der Erzeugung eines Pulssteuersignals im Rahmen der erfindungsgemäßen Lösung aus einem ersten Pulssignalzug und einem zweiten Pulssignalzug durch ODER-Verknüpfung;
- Fig. 4: eine exemplarische Darstellung des Steuersignals bei verschiedenen Teillastwerten im Rahmen der erfindungsgemäßen Lösung;
- Fig. 5: eine schematische Darstellung der Aufteilung des oberen Teillastbereichs in einen normalen oberen Teillastbereich und einen höchsten oberen Teillastbereich;
- Fig. 6: eine schematische Darstellung einer Variante des ersten Ausführungsbeispiels, bei welcher stets lediglich eines der Pulssignale pulsweitenmoduliert wird, während das andere nicht pulsweitenmoduliert wird;
- Fig. 7: eine schematische Darstellung der erfindungsgemäß möglichen Reduzierung der erzeugten Wärme;
- Fig. 8: eine Darstellung eines tatsächlichen Steuersignals mit dem entsprechenden über eine induktive Last fließenden Strom bei geringer Pulsweite des ersten Pulssignals und
- Fig. 9: eine Darstellung eines tatsächlichen Steuersignals mit großer Pulsweite und dementsprechenden Strom durch eine induktive Last mit Freilaufdiode.

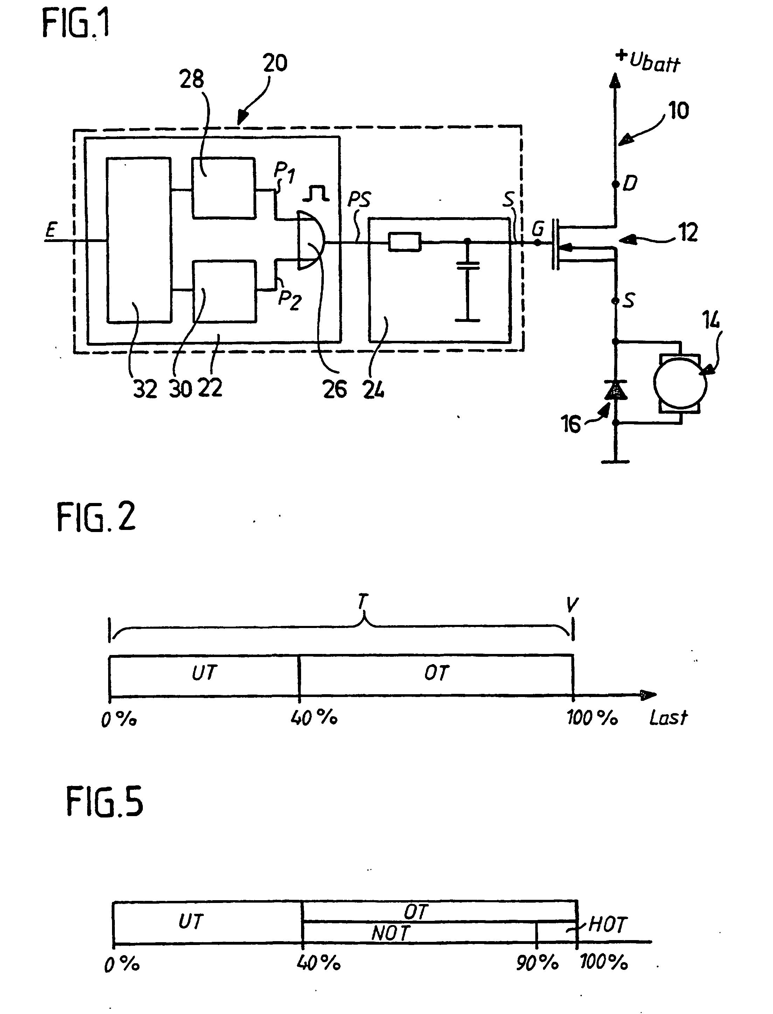

Ein Ausführungsbeispiel einer erfindungsgemäßen Steuerschaltung, dargestellt in Fig. 1, umfaßt einen Laststromkreis 10, welcher zwischen einer positiven Speisespannung U_{batt} und Masse verläuft und in welchem ein als Ganzes mit 12 bezeichneter Halbleiterschalter angeordnet ist, welcher beispielsweise als MOSFET ausgebildet ist, wobei ein Drain-Anschluß D mit der positiven Speisespannung U_{batt} verbunden ist, ein Gate-Anschluß G zum Ansteuern vorgesehen ist und ein Source-Anschluß mit einer Last 14, beispielsweise einer induktiven Last in Form insbesondere eines Motors, verbunden ist. Dieser induktiven Last 14 ist ferner eine Freilaufdiode 16 parallelgeschaltet, so daß die Last 14 und die parallelgeschaltete Freilaufdiode 16 einerseits mit dem Source-Anschluß S des Halbleiterschalters 12 verbunden sind und andererseits auf Masse liegen.

Zum Ansteuern des Halbleiterschalters 12 ist im Fall des MOSFET-Halbleiterschalters der Gate-Anschluß G mit einer Ansteuerung 20 verbunden, die ein dem Gate-Anschluß G zugeführtes Steuersignal S erzeugt, das aufeinanderfolgende und durch Pulspausen getrennte Ansteuerpulse umfaßt. Dieses Steuersignal S wird durch einen Pulsgenerator 22 und eine nachfolgende Pulsformerstufe 24 erzeugt, wobei der Pulsgenerator 22 Rechteckpulse generiert, deren Flankensteilheit durch die Pulsformerstufe 24 festgelegt wird, beispielsweise derart, daß die Anstiegs- und Abstiegsflanken ausreichend lange verzögert sind, um der Freilaufdiode 16 ausreichend Zeit zum Einschalten bzw. Ausschalten zu geben.

Vorzugsweise umfaßt der Pulsgenerator 22 ein ODER-Gatter 26, zwei Pulssignalgeneratoren 28 und 30 und einen Steuerrechner 32, welcher die Pulssignalgeneratoren 28 und 30 ansteuert, so daß diese ihrerseits Pulssignalzüge P₁ bzw. P₂ erzeugen, welche in dem Addierglied 26 zu einem Pulssteuersignal PS addiert werden.

Der Steuerrechner 32 erhält über ein Eingangssignal E die Information darüber, mit welcher Leistung die Last 14 betrieben werden soll.

Intern wird, wie in Fig. 2 dargestellt, in dem Steuerrechner ausgehend von dem Eingangssignal E differenziert zwischen einem unteren Teillastbereich UT und einem oberen Teillastbereich OT, wobei vorzugsweise der untere Teillastbereich UT bei einer Leistungseinspeisung von 0 % bezogen auf Vollast beginnt und im Teillastbereich T bis zu einer Teillast von beispielsweise 40 % bezogen auf Vollast reicht. Unmittelbar daran schließt sich dann der obere Teillastbereich OT an, welcher bis zur vollen Leistung V, d. h. der Leistung von 100 % reicht, so daß der gesamte Teillastbereich T sich lückenlos aus dem unteren Teillastbereich und dem oberen Teillastbereich ergibt.

Es ist aber auch denkbar, den Teillastbereich so zu wählen, daß dieser weder bei 0 % beginnt noch bei 100 % endet, sondern zwischen diesen Werten liegt.

Ergibt sich aus dem Eingangssignal E, daß die Last 14 im oberen Teillastbereich OT betrieben werden soll, so steuert der Steuerrechner 32 den ersten Pulssignalgenerator 28 derart an, daß dieser einen Pulssignalzug P₁ mit einer ersten Frequenz f₁ erzeugt, dessen Einzelpulse PE₁ jeweils nach Zeitintervallen Δt₁ starten, die der Frequenz f₁ entsprechen.

Diese Einzelpulse PE₁ haben dabei eine Pulsweite PW₁, welche durch den Steuerrechner 32 einstellbar ist, während die Frequenz f₁ der Einfachheit halber nicht einstellbar ist, sondern fest dem ersten Pulssignalgenerator 28 vorgebbar ist.

Die Einstellung der Pulsweite PW₁ erfolgt, wie nachher im einzelnen dargelegt, entsprechend der an der Last gewünschten Leistung.

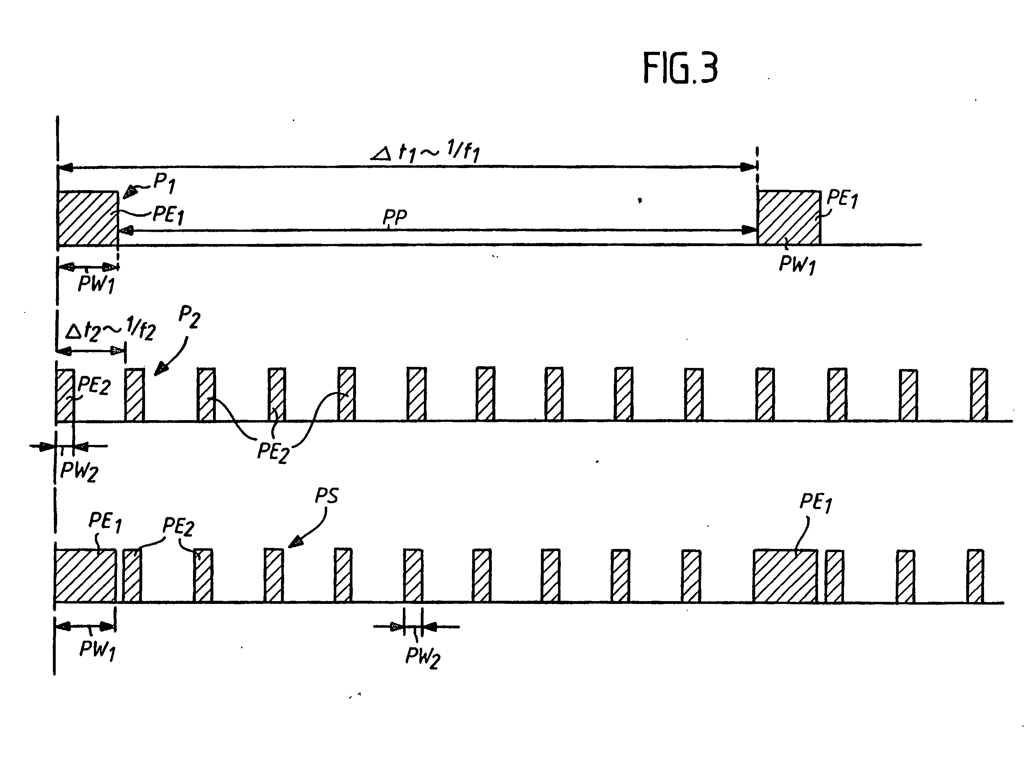

Ferner steuert der Steuerrechner 32 den zweiten Pulssignalgenerator 30 an, welcher einen zweiten Pulssignalzug P₂, ebenfalls dargestellt in Fig. 3, erzeugt, wobei der zweite Pulssignalzug P₂ Einzelpulse erzeugt, die mit einer zweiten Frequenz f₂ aufeinanderfolgen und somit in einem Zeitintervall Δt₂ entsprechend dieser zweiten Frequenz f₂ aufeinanderfolgend erzeugt werden.

Dabei beträgt die Frequenz f₂ mindestens das Zehnfache der Frequenz f₁, vorzugsweise werden bei der Frequenz f₂ Frequenzen in der Größenordnung von 10 kHz oder mehreren 10 kHz gewählt, während die Frequenzen f₁ in der Größenordnung von einigen 100 Hz liegen, so daß vorzugsweise die Frequenz f₂ größenordnungsmäßig das Einhundertfache der Frequenz f₁ beträgt.

Auch die Pulsweite PW₂ der Einzelpulse PE₂ des zweiten Pulssignalgenerators 30 ist durch den Steuerrechner 32 einstellbar, während die Frequenz des zweiten Pulssignalgenerators üblicherweise ebenfalls fest vorgegeben ist.

Wie in Fig. 3 dargestellt, werden nun die beiden Pulssignalzüge P₁ und P₂ durch das Addierglied 26 oder ODER-Gatter miteinander so verknüpft, daß als Ergebnis ein Pulssteuersignal PS entsteht, das die logische ODER-Verknüpfung beider Pulssignalzüge P₁ und P₂ darstellt, so daß das Pulssteuersignal PS einmal die Einzelpulse PE₁ des ersten Pulssignalzuges P₁ zeigt, da während der Zeit, während der die Einzelpulse PE₁ vorliegen, die Existenz der Einzelpulse PE₂ des zweiten Pulssignalzuges P₂ unerheblich ist, insbesondere dann, wenn die Einzelpulse PE₁ eine größere Pulsweite PW₁ aufweisen als die Einzelpulse PE₂ des zweiten Pulssignalzuges.

Während der Pulspausen PP zwischen den Einzelpulsen PE₁ des ersten Pulssignalzuges P₁ treten dann jedoch in dem Pulssteuersignal PS die Einzelpulse PE₂ des zweiten Pulssignalzuges P₂ auf.

Da vorzugsweise die Pulsweiten PW₁ der Einzelpulse PE₁ des ersten Pulssignalzuges P₁ in der Regel größer sind als die Pulsweiten PW₂ der Einzelpulse PE₂ des zweiten Pulssignalzugs P₂, erfolgt jeweils bei Auftreten der Einzelpulse PE₁ in dem Pulssteuersignal PS ein längeres Durchschalten des Halbleiterschalters 12 im Vergleich zum Durchschalten des Halbleiterschalters 12 beim Auftreten eines Einzelpulses PE₂ aus dem zweiten Pulssignalzug P₂ während der Pulspausen PP zwischen den Einzelpulsen PE₁ des ersten Pulssignalzugs P₁.

In dem oberen Teillastbereich OT besteht nunmehr die Möglichkeit, die der Last 14 zugeführte Leistung dadurch zu steuern, daß entweder die Pulsweite PW₁ der Einzelpulse PE₁ des ersten Pulssignalzuges P₁ oder die Pulsweite PW₂ der Einzelpulse PE₂ des zweiten Pulssignalzuges P₂ oder die Pulsweiten PW₁ und PW₂ beider Pulssignalzüge P₁ und P₂ variiert werden, so daß die der Last 14 zuzuführende Leistung beliebig fein und präzise einstellbar ist.

Vorzugsweise wird jedoch im oberen Teillastbereich OT so gearbeitet, daß die Pulsweite PW₂ der Einzelpulse PE₂ des zweiten Pulssignalzuges P₂ möglichst klein gehalten wird, im Gegensatz zu einer möglichst großen Pulsweite PW₁ der Einzelpulse PE₁ des ersten Pulssignalzuges P₁, da mit steigender Pulsweite PW₁ der Einzelpulse PE₁ des ersten Pulssignalzuges die Zahl der Ein- und Ausschaltvorgänge reduziert werden kann, wenn sich die Pulsweite PW₁ über mindestens ein Intervall Δt₂ des zweiten Pulssignalzuges P₂ erstreckt und mit zunehmender Pulsweite PW₁ der Einzelpulse PE₁ des ersten Pulssignalzuges P₁ insgesamt die Zahl der Ein- und Ausschaltvorgänge pro Zeiteinheit abnimmt, da innerhalb des Zeitintervalls Δt₁ für eine immer größere Dauer die Last 14 aufgrund des Durchsteuerns des Halbleiterschalters 12 dauergespeist ist.

Dagegen wird vorzugsweise im unteren Teillastbereich UT nur das Pulssteuersignal PS basierend auf dem zweiten Pulssignalzug P₂ mit variabler Pulsweite PW₂ erzeugt.

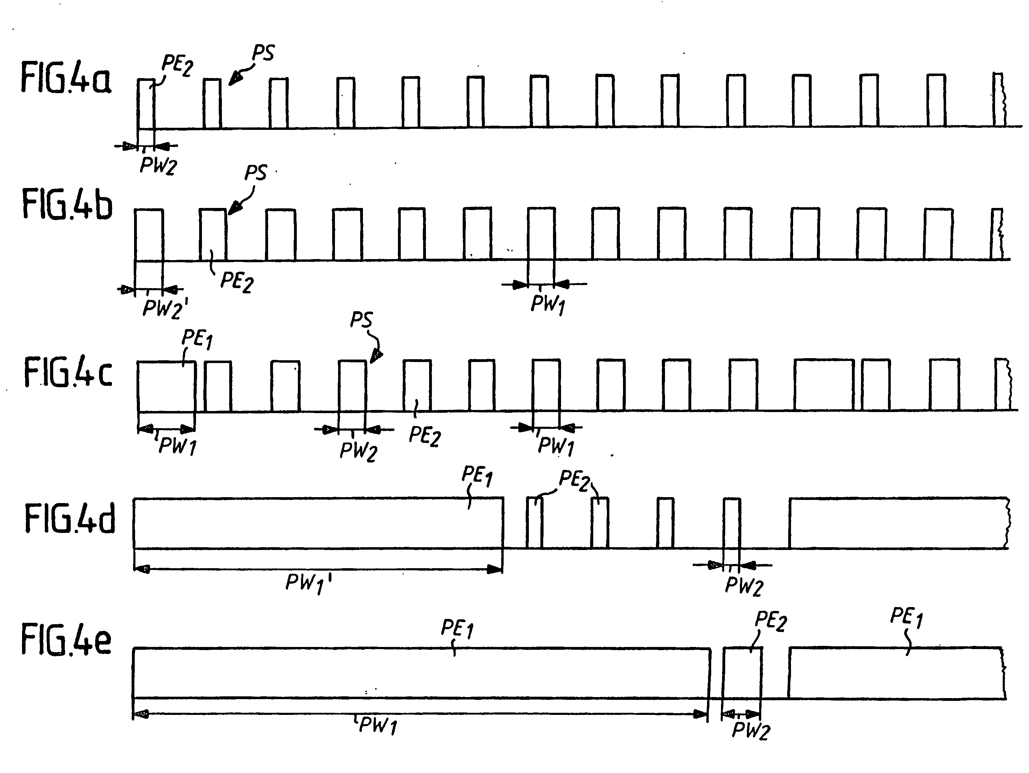

Eine derartige Art der Leistungssteuerung der Last 14 ist exemplarisch in Fig. 4 an mehreren Stellen des Teillastbereichs T angegeben.

So ist beispielsweise in Fig. 4a bei einem Teillastbereich von 25 % bezogen auf Vollast die Pulsweite PW₂ so gewählt, daß sie einem Viertel des Zeitintervalls Δt₂ entspricht, das zwischen dem Anfang zweier aufeinanderfolgender Einzelpulse PE₂ des zweiten Pulssignalzuges liegt. Soll, wie in Fig. 4b dargestellt, mit einer Teillast von 40 % gearbeitet werden, so ist die Pulsweite PW₂' des Pulssteuersignals, das immer noch aus Einzelpulsen PE₂ des zweiten Pulssignalzuges P₂ zusammengesetzt ist, vergrößert.

Wird nun, wie in Fig. 4c dargestellt, vom unteren Teillastbereich in den oberen Teillastbereich übergegangen, der beispielsweise bei ungefähr 40 % beginnt, so zeigt das Pulssteuersignal PS, wie in Fig. 4c exemplarisch dargestellt, einerseits die Einzelpulse PE₂ mit der Pulsweite PW₂ des zweiten Pulssignalzuges P₂, jedoch zusätzlich die Einzelpulse PE₁ mit der Pulsweite PW₁ des ersten Pulssignalzuges P₁, wobei die Einzelpulse PE₂ des zweiten Pulssignalzuges P₂ nur in den Pulspausen PP zwischen aufeinanderfolgenden Einzelpulsen PE₁ des ersten Pulssignalzuges P₁ auftreten.

In dem oberen Teillastbereich OT kann somit bei Erhöhung der der Last 14 zur Verfügung zu stellenden Leistung sowohl die Pulsweite PW₂ des zweiten Pulssignalzuges P₂ als auch die Pulsweite PW₁ des ersten Pulssignalzuges P₁ gesteuert werden. Vorzugsweise wird die Pulsweite PW₁ der Einzelpulse PE₁ des ersten Pulssignalzuges mit zunehmender der Last 14 zur Verfügung gestellter Leistung vergrößert, während eine Variation der Pulsweite PW₂ der Einzelpulse PE₂ des zweiten Pulssignalzuges nur zur möglichst feinstufigen Leistungseinstellung erfolgt.

Die Steigerung der Pulsweite PW₁ der Einzelpulse PE₁ des ersten Pulssignalzuges kann so weit erfolgen, daß in der Pulspause PP zwischen aufeinanderfolgenden Einzelpulsen PE₁ nur noch einer oder einige wenige Einzelpulse PE₂ auftreten.

Um nahe der vollen Leistung möglichst präzise steuern zu können, ist vorzugsweise vorgesehen, daß im Bereich nahe Vollast im wesentlichen die Leistungssteuerung durch Einstellung der Pulsweite PW₂ der Einzelpulse PE₂ des zweiten Pulssignalzuges erfolgt.

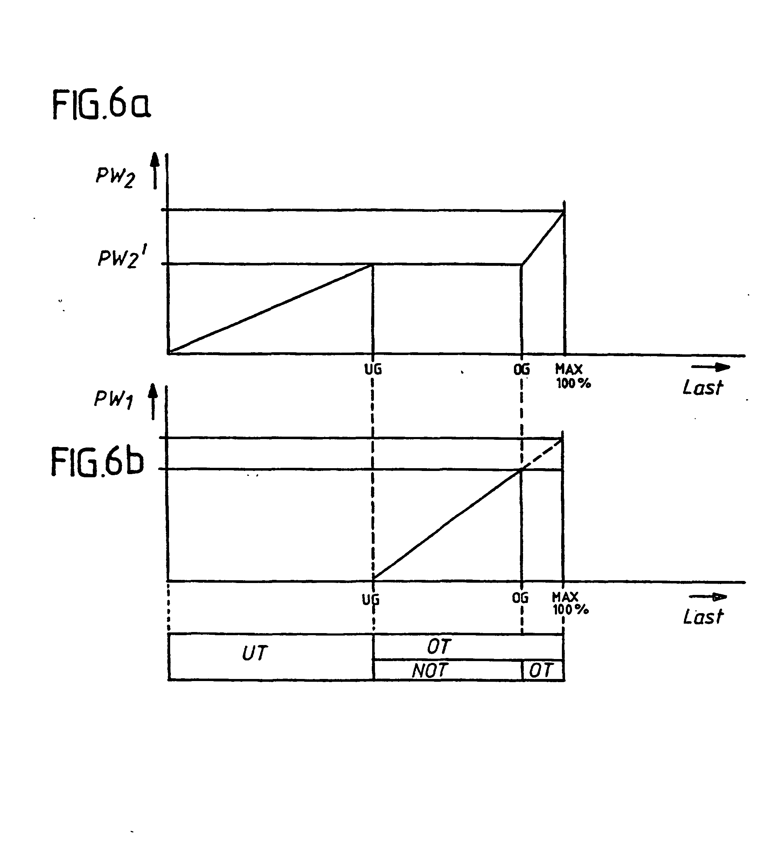

Um insbesondere nahe des Vollastbereichs möglichst präzise die Leistung steuern zu können, wird vorzugsweise der obere Teillastbereich, wie in Fig. 5 dargestellt, in einen normalen oberen Teillastbereich NOT unterteilt, welcher beispielsweise von 40 % Teillast bis 90 % Teillast reicht und in einen höchsten oberen Teillastbereich HOT, welcher von 90 % bis 100 % reicht.

In diesem höchsten oberen Teillastbereich HOT wird ausgehend von dem Wert der Pulsweite PW₁ der Einzelpulse PE₁ des ersten Pulssignalzuges bei 90 % auch bei einer Leistungserhöhung die Pulsweite PW₁ nicht mehr geändert, sondern es folgt eine Leistungssteuerung über die Variation der Pulsweite PW₂ der wenigen Einzelpulse PE₁ des zweiten Pulssignalzuges P₂ in den Pulspausen PP zwischen aufeinanderfolgenden Einzelpulsen PE₁, um diese Steuerung möglichst präzise vornehmen zu können.

Prinzipiell wäre dabei in dem normalen oberen Teillastbereich NOT sowohl eine Variation der Pulsweite PW₁ als auch eine Variation der Pulsweite PW₂ zur Leistungseinstellung möglich.

Besonders einfach ist diese Vorgehensweise im normalen oberen Teillastbereich NOT dann, wenn ausgehend vom Übergang vom unteren Teillastbereich UT in den oberen Teillastbereich OT die maximale Pulsweite PW₂ beibehalten wird, die bei maximaler Leistungseinspeisung Last im unteren Teillastbereich UT vorliegt und dann zusätzlich die Einzelpulse PE₁ mit der Pulsweite PW₁ des ersten Pulssignalzuges P₁ hinzugefügt werden, die dann einen oder mehrere Einzelpulse PE₂ des zweiten Pulssignalzuges P₂ ersetzen, wobei die gesamte Leistungssteuerung im normalen oberen Teillastbereich vorzugsweise ausschließlich über die Pulsweite PW₁ bei konstanter Pulsweite PW₂' erfolgt, bis der höchste obere Teillastbereich HOT erreicht ist.

Eine derartige Vorgehensweise ist in Fig. 6a und b dargestellt. Gemäß Fig. 6a wird die Pulsweite PW₂ im unteren Teillastbereich UT, beginnend von einem Wert im wesentlichen nahe 0 % bis zum Wert PW₂' erhöht, bei welchem ein Übergang vom unteren Teillastbereich in den oberen Teillastbereich erfolgt, wobei im normalen oberen Teillastbereich, wie in Fig. 6 dargestellt, die Leistungssteuerung ausschließlich durch Variation der Pulsweite PW₁ erfolgt bis zum Erreichen des höchsten oberen Teillastbereichs HOT, in welchem wiederum die Pulsweite PW₁ dann auf dem maximalen Wert des normalen oberen Teillastbereichs konstant gehalten wird, während die Leistungssteuerung ausschließlich über die Pulsweite PW₂ erfolgt, die hierzu über den Wert PW₂', welcher den maximalen Wert beim Übergang vom unteren Teillastbereich in den oberen Teillastbereich repräsentiert, hinaus erhöht wird.

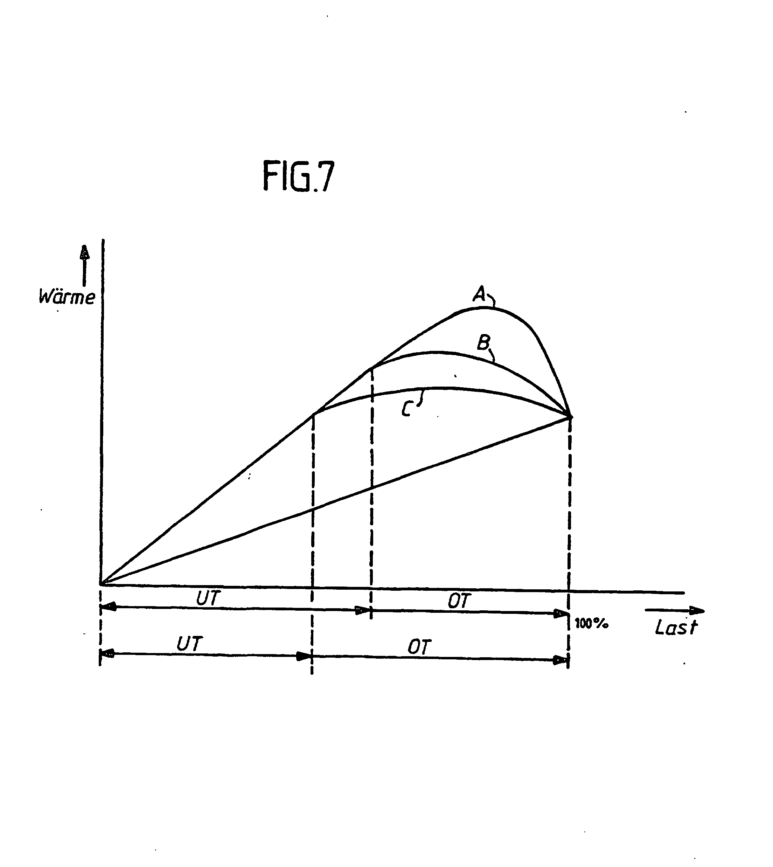

Wie in Fig. 7 dargestellt, erlaubt es die erfindungsgemäße Lösung, die insgesamt bei der erfindungsgemäßen Steuerschaltung anfallenden thermischen Verluste zu reduzieren. Fig. 7 zeigt in Form der Kurve A den Verlauf der Wärmeverluste dann, wenn die gesamte Leistungssteuerung über den gesamten Bereich mittels des zweiten Pulssignalzuges P₂ und der Variation der Pulsweite PW₂ erfolgt.

Wird hingegen, wie durch die Kurve B dargestellt, im oberen Teillastbereich OT mit einer Kombination aus den Einzelpulsen PE₁ des ersten Pulssignalzuges P₁ und den Einzelpulsen PE₂ des zweiten Pulssignalzuges P₂ die Leistung gesteuert, so lassen sich die Wärmeverluste deutlich reduzieren. Noch deutlicher lassen sich die Wärmeverluste reduzieren, wenn der Übergang vom unteren Teillastbereich UT in den oberen Teillastbereich OT zu möglichst niedrigen Werten der Teillast gelegt wird, wie die Kurve C zeigt.

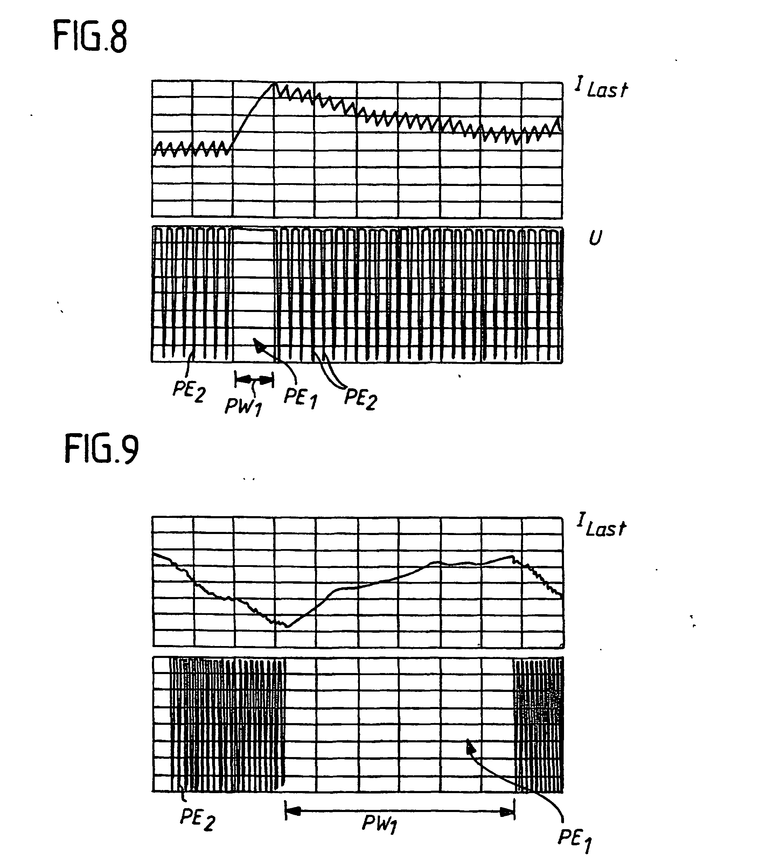

Der sich tatsächlich einstellende Strom I_{Last} an der Last 14 ist in Fig. 8 für einen Fall ähnlich Fig. 4c dargestellt, d. h., für den Fall, daß die Pulsweite PW₁ so gering ist, daß sie sich über wenige Einzelpulse PE₂ des zweiten Pulssignalzuges P₂ erstreckt. In diesem Fall steigt der über die Last 14 fließende Strom I_{Last} während des Einzelpulses PE₁ an und fällt dann langsam ab, wobei der Strom I_{Last} sich entsprechend der Folge von Einzelpulsen PE₂ ändert.

Wird dagegen, wie in Fig. 9 dargestellt, die Pulsweite PW₁ eines Einzelpulses PE₁ größer gewählt, so wird der Verlauf des Stromes I_{Last} über die Last 14 primär durch die Einzelpulse PE₁ mit der Pulsweite PW₁ dominiert und nur noch in geringem Maße von den Einzelpulsen PE₂ in den Pulspausen des ersten Pulssignalzuges P₁.

## Patentansprüche

1. Steuerschaltung zum leistungsgesteuerten Betreiben einer Last (14), umfassend einen in einem Laststromkreis (10) wirksamen Halbleiterschalter (12), welcher zur Leistungssteuerung der Last (14) eine Speisespannung (U_{bar}) pulsweitenmoduliert, und eine Ansteuerung (20) für den Halbleiterschalter (12), welche zur Leistungssteuerung sowohl in einem unteren Teillastbereich (UT) als auch in einem zwischen dem unteren Teillastbereich (UT) und Vollast liegenden oberen Teillastbereich (OT) ein Pulssteuersignal (PS), umfassend aufeinanderfolgende und durch Pulspausen getrennte pulsweitenmodulierte Pulssteuersignale (P₁, P₂), erzeugt,
**dadurch gekennzeichnet, daß** die Ansteuerung (20) über ein Eingangssignal (E) Information darüber erhält, mit welcher Leistung die Last (14) betrieben werden soll, daß die Ansteuerung (20) differenziert, ob die Leistung mit der die Last (14) betrieben werden soll, im unteren Teillastbereich (UT) oder im oberen Teillastbereich (OT) liegt, daß die Ansteuerung (20) in dem oberen Teillastbereich (OT) als Pulssteuersignal (PS) ein erstes Pulssignal (P₁) mit mit einer ersten Pulsfrequenz (f₁)fortlaufend aufeinanderfolgenden ersten Einzelpulsen (PE₁) sowie in den Pulspausen (PP) des ersten Pulssignals (P₁) ein zweites Pulssignal (P₂) mit mit einer zweiten Frequenz (f₂) fortlaufend aufeinanderfolgenden zweiten Einzelpulsen (PE₂) erzeugt, wobei die zweite Frequenz (f₂) mindestens um einen Faktor 10 größer als die erste Frequenz (f₁) ist und wobei in dem oberen Teillastbereich (OT) mindestens eines der ersten und zweiten Pulssignale (P₁, P₂) zur Leistungssteuerung pulsweitenmodulierbar ist, und daß die Ansteuerung (20) in dem unteren Teillastbereich (UT) als Pulssteuersignal (PS) ein drittes Pulssignal mit einer dritten Frequenz erzeugt, die größer als die erste Frequenz (f₁) ist.

2. Steuerschaltung nach Anspruch 1, **dadurch gekennzeichnet, daß** in dem oberen Teillastbereich (OT) nur eines der Pulssignale (P₁, P₂) pulsweitenmodulierbar ist.

3. Steuerschaltung nach Anspruch 1 oder 2, **dadurch gekennzeichnet, daß** der obere Teillastbereich (OT) in einen höchsten oberen Teillastbereich (HOT) und einen normalen oberen Teillastbereich (NOT) unterteilbar ist und daß in dem normalen oberen Teillastbereich (NOT) die Einzelpulse (PE₁) des ersten Pulssignals (P₁) pulsweitenmodulierbar sind und daß in dem höchsten oberen Teillastbereich (HOT) die Einzelpulse (PE₂) des zweiten Pulssignals (P₂) pulsweitenmodulierbar sind.

4. Steuerschaltung nach Anspruch 3, **dadurch gekennzeichnet, daß** in dem normalen oberen Teillastbereich (NOT) die Pulsweite (PW₂) der Einzelpulse (PE₂) des zweiten Pulssignals (P₂) konstant ist.

5. Steuerschaltung nach Anspruch 3 oder 4, **dadurch gekennzeichnet, daß** in dem höchsten oberen Teillastbereich (HOT) die Pulsweite (PW₂) der Einzelpulse (PE₂) des ersten Pulssignals (P₁) konstant ist.

6. Steuerschaltung nach einem der voranstehenden Ansprüche, **dadurch gekennzeichnet, daß** die dritte Frequenz in derselben Größenordnung liegt wie die zweite Frequenz (f₂).

7. Steuerschaltung nach Anspruch 6, **dadurch gekennzeichnet, daß** die dritte Frequenz und die zweite Frequenz (f₂) ungefähr gleich groß sind.

8. Steuerschaltung nach Anspruch 7, **dadurch gekennzeichnet, daß** die dritte Frequenz mit der zweiten Frequenz (f₂)identisch ist.

9. Steuerschaltung nach einem der voranstehenden Ansprüche, **dadurch gekennzeichnet, daß** der Übergang von dem unteren Teillastbereich (UT) in den oberen Teillastbereich (OT) bei Teillastwerten im Bereich von ungefähr 20 % bis ungefähr 50 % erfolgt.

10. Steuerschaltung nach Anspruch 9, **dadurch gekennzeichnet, daß** der Übergang vom unteren Teillastbereich (UT) in den oberen Teillastbereich (OT) bei Teillastwerten im Bereich von ungefähr 30 % bis ungefähr 40 % erfolgt.

11. Steuerschaltung nach einem der voranstehenden Ansprüche, **dadurch gekennzeichnet, daß** die zweite Frequenz (f₂) und/oder die dritte Frequenz um einen Faktor in der Größenordnung von 30 oder mehr größer als die erste Frequenz (f₁) ist.

12. Steuerschaltung nach einem der voranstehenden Ansprüche, **dadurch gekennzeichnet, daß** der obere Teillastbereich (OT) sich unmittelbar an den unteren Teillastbereich (UT) anschließt.

13. Steuerschaltung nach Anspruch 12, **dadurch gekennzeichnet, daß** der untere Teillastbereich (UT) und der obere Teillastbereich (OT) den gesamten Teillastbereich bis zur Vollast abdecken.

14. Steuerschaltung nach einem der voranstehenden Ansprüche, **dadurch gekennzeichnet, daß** die Ansteuerung (20) einen Pulsgenerator (22) und eine Pulsformerstufe (24) aufweist.

15. Steuerschaltung nach einem der voranstehenden Ansprüche, **dadurch gekennzeichnet, daß** das erste Pulssignal (P₁) und das zweite Pulssignal (P₂) als fortlaufend aufeinanderfolgende Einzelpulse (PE₁, PE₂) aufweisende Pulssignalzüge (P₁, P₂) mit konstanter Frequenz (f₁, f₂) erzeugbar sind und daß aus den Pulssignalzügen (P₁, P₂) durch ODER-Verknüpfung das Steuersignal (S) für den oberen Teillastbereich (OT) entsteht.

16. Verfahren zum leistungsgesteuerten Betreiben einer Last (14) mittels einer Steuerschaltung, umfassend einen in einem Laststromkreis (10) wirksamen Halbleiterschalter (12), welcher zur Leistungssteuerung der Last (14) eine Speisespannung (U_{bar}) pulsweitenmoduliert, und eine Ansteuerung (20) für den Halbleiterschalter (12), welche zur Leistungssteuerung sowohl in einem unteren Teillastbereich (UT) als auch in einem zwischen dem unteren Teillastbereich (UT) und Vollast liegenden oberen Teillastbereich (OT) ein Pulssteuersignal (PS) umfassend aufeinanderfolgende, durch Pulspausen getrennte pulsweitenmodulierte Pulssteuersignale (P₁, P₂) erzeugt,
**dadurch gekennzeichnet, daß** die Ansteuerung (20) über ein Eingangssignal (E) darüber informiert wird, mit welcher Leistung die Last (14) betrieben werden soll, daß von der Ansteuerung (20) differenziert wird, ob die Leistung, mit der die Last betrieben werden soll, im unteren Teillastbereich (UT) oder im oberen Teillastbereich (OT) liegt, daß von der Ansteuerung (20) in dem oberen Teillastbereich (OT) als Pulssteuersignal (PS) ein erstes Pulssignal (P₁) mit mit einer ersten Pulsfrequenz (f₁)fortlaufend aufeinanderfolgenden Einzelpulsen (PE₁) sowie in den Pulspausen (PP) des ersten Pulssignals (P₁) ein zweites Pulssignal (P₂) mit mit einer zweiten Pulsfrequenz (f₂) fortlaufend aufeinanderfolgenden Einzelpulsen (PE₂) erzeugt wird, wobei die zweite Pulsfrequenz (f₂) mindestens um einen Faktor 10 größer als die erste Pulsfrequenz (f₁) ist und wobei die Leistungssteuerung durch Pulsweitenmodulation mindestens eines der ersten und zweiten Pulssignale (P₁, P₂) durchgeführt wird, und daß von der Ansteuerung (20) in dem unteren Teillastbereich (UT) ein Pulssteuersignal (PS) erzeugt wird, welches ein drittes Pulssignal mit einer dritten Frequenz umfaßt, die größer ist als die erste Frequenz (f₁).

17. Verfahren nach Anspruch 16, **dadurch gekennzeichnet, daß** nur die Pulsweite (PW) eines der Pulssignale (P₁, P₂) moduliert wird, während das andere der Pulssignale (P₂, P₁) konstant gehalten wird.

18. Verfahren nach einem der Ansprüche 16 oder 17, **dadurch gekennzeichnet, daß** der obere Teillastbereich (OT) in einen höchsten oberen Teillastbereich (HOT) und einen normalen oberen Teillastbereich (NOT) aufgeteilt wird.

19. Verfahren nach Anspruch 18, **dadurch gekennzeichnet, daß** in dem normalen oberen Teillastbereich (NOT) das erste Pulssignal (P₁) hinsichtlich der Pulsweite (PW) zur Leistungssteuerung moduliert wird.

20. Verfahren nach Anspruch 18 oder 19, **dadurch gekennzeichnet, daß** in dem höchsten oberen Teillastbereich (HOT) das zweite Pulssignal (P₂) zur Steuerung der Leistung moduliert wird.

21. Verfahren nach einem der Ansprüche 18 bis 20, **dadurch gekennzeichnet, daß** das jeweils andere Pulssignal (P₂, P₁) hinsichtlich seiner Pulsweite (PW) konstant gehalten wird.

22. Verfahren nach einem der Ansprüche 16 bis 21, **dadurch gekennzeichnet, daß** die dritte Frequenz in derselben Größenordnung liegt wie die zweite Frequenz (f₂).

23. Verfahren nach Anspruch 22, **dadurch gekennzeichnet, daß** die dritte Frequenz mit der zweiten Frequenz (f₂) im wesentlichen identisch ist.

24. Verfahren nach einem der Ansprüche 21 bis 23, **dadurch gekennzeichnet, daß** der untere Teillastbereich (UT) und der obere Teillastbereich (OT) den gesamten Teillastbereich bis zur Vollast abdecken.

25. Verfahren nach einem der Ansprüche 16 bis 24, **dadurch gekennzeichnet, daß** das erste Pulssignal (P₁) und das zweite Pulssignal (P₂) als fortlaufende Pulssignalzüge (PS) mit konstanter Frequenz erzeugt werden und durch ODER-Verknüpfung aus den beiden Pulssignalzügen (P₁, P₂) das Steuersignal im oberen Teillastbereich (OT) erzeugt wird.

## Claims

1. Control circuit for the power-controlled operation of a load (14), comprising a semiconductor switch (12) which is effective in a load circuit (10) and pulse-width modulates a supply voltage (U_{bar}) for power control of the load (14), and comprising a drive circuit (20) for the semiconductor switch (12), which drive circuit generates a pulse control signal (PS), comprising pulse-width modulated pulse control signals (P₁, P₂) following one after the other and separated by interpulse periods, for power control both in a lower part-load range (UT) and also in an upper part-load range (OT) lying between the lower part-load range (UT) and full load, **characterized in that** the drive circuit (20) receives information via an input signal (E) as to the power with which the load (14) is to be driven, **in that** the drive circuit (20) differentiates whether the power with which the load (14) is to be driven lies in the lower part-load range (UT) or in the upper part-load range (OT), **in that** the drive circuit (20) generates in the upper part-load range (OT), as a pulse control signal (PS), a first pulse signal (P₁), with first individual pulses (PE₁) following continuously one after the other with a first pulse frequency (f₁), and, in the interpulse periods (PP) of the first pulse signal (P₁), a second pulse signal (P₂), with second individual pulses (PE₂) following continuously one after the other with a second frequency (f₂), the second frequency (f₂) being greater than the first frequency (f₁) at least by a factor of 10, and, in the upper part-load range (OT), at least one of the first and second pulse signals (P₁, P₂) being capable of being pulse-width-modulated for power control, and **in that**, in the lower part-load range (UT), the control circuit (20) generates, as a pulse control signal (PS), a third pulse signal, with a third frequency, which is greater than the first frequency (f₁).

2. Control circuit according to Claim 1, **characterized in that** in the upper part-load range (OT) only one of the pulse signals (P₁, P₂) can be pulse-width-modulated.

3. Control circuit according to Claim 1 or 2, **characterized in that** the upper part-load range (OT) can be divided into a highest upper part-load range (HOT) and a normal upper part-load range (NOT) and **in that** the individual pulses (PE₁) of the first pulse signal (P₁) can be pulse-width-modulated in the normal upper part-load range (NOT) and **in that** the individual pulses (PE₂) of the second pulse signal (P₂) can be pulse-width-modulated in the highest upper part-load range (HOT).

4. Control circuit according to Claim 3, **characterized in that** in the normal upper part-load range (NOT), the pulse width (PW₂) of the individual pulses (PE₂) of the second pulse signal (P₂) is constant.

5. Control circuit according to Claim 3 or 4, **characterized in that** in the highest upper part-load range (HOT), the pulse width (PW₂) of the individual pulses (PE₂) of the first pulse signal (P₁) is constant.

6. Control circuit according to one of the preceding claims, **characterized in that** the third frequency is of the same order of magnitude as the second frequency (f₂).

7. Control circuit according to Claim 6, **characterized in that** the third frequency and the second frequency (f₂) are approximately of the same magnitude.

8. Control circuit according to Claim 7, **characterized in that** the third frequency is identical to the second frequency (f₂).

9. Control circuit according to one of the preceding claims, **characterized in that** the transition from the lower part-load range (UT) into the upper part-load range (OT) takes place at part-load values in the range from approximately 20% to approximately 50%.

10. Control circuit according to Claim 9, **characterized in that** the transition from the lower part-load range (UT) into the upper part-load range (OT) takes place at part-load values in the range from approximately 30% to approximately 40%.

11. Control circuit according to one of the preceding claims, **characterized in that** the second frequency (f₂) and/or the third frequency is greater than the first frequency (f₁) by a factor of the order of magnitude of 30 or more.

12. Control circuit according to one of the preceding claims, **characterized in that** the upper part-load range (OT) follows on directly from the lower part-load range (UT).

13. Control circuit according to Claim 12, **characterized in that** the lower part-load range (UT) and the upper part-load range (OT) cover the entire part-load range up to full load.

14. Control circuit according to one of the preceding claims, **characterized in that** the drive circuit (20) has a pulse generator (22) and a pulse-shaping stage (24).

15. Control circuit according to one of the preceding claims, **characterized in that** the first pulse signal (P₁) and the second pulse signal (P₂) can be generated as pulse signal trains (P₁, P₂) having individual pulses (PE₁, PE₂) following continuously one after the other with constant frequency (f₁, f₂) and **in that** the control signal (S) for the upper part-load range (OT) is produced from the pulse signal trains (P₁, P₂) by conducting an OR operation.

16. Method for the power-controlled operation of a load (14) by means of a control circuit, comprising a semiconductor switch (12) which is effective in a load circuit (10) and pulse-width modulates a supply voltage (U_{bar}) for power control of the load (14), and comprising a drive circuit (20) for the semiconductor switch (12), which drive circuit generates a pulse control signal (PS), comprising pulse-width-modulated pulse drive signals (P₁, P₂) following one after the other and separated by interpulse periods, for power control both in a lower part-load range (UT) and also in an upper part-load range (OT) lying between the lower part-load range (UT) and full load, **characterized in that** the drive circuit (20) is informed via an input signal (E) as to the power with which the load (14) is to be driven, **in that** it is differentiated by the drive circuit (20) whether the power with which the load is to be driven lies in the lower part-load range (UT) or in the upper part-load range (OT), **in that** there is generated by the drive circuit (20) in the upper part-load range (OT), as a pulse control signal (PS), a first pulse signal (P₁), with individual pulses (PE₁) following continuously one after the other with a first pulse frequency (f₁), and, in the interpulse periods (PP) of the first pulse signal (P₁), there is generated a second pulse signal (P₂), with individual pulses (PE₂) following continuously one after the other with a second pulse frequency (f₂), the second pulse frequency (f₂) being greater than the first pulse frequency (f₁) at least by a factor of 10, and the power control being carried out by pulse width modulation of at least one of the first and second pulse signals (P₁, P₂), and **in that** there is generated by the drive circuit (20) in the lower part-load range (UT), a pulse control signal (PS) which comprises a third pulse signal with a third frequency, which is greater than the first frequency (f₁).

17. Method according to Claim 16, **characterized in that** only the pulse width (PW) of one of the pulse signals (P₁, P₂) is modulated, whereas the other of the pulse signals (P₂, P₁) is kept constant

18. Method according to one of Claims 16 or 17, **characterized in that** the upper part-load range (OT) is divided into a highest upper part-load range (HOT) and a normal upper part-load range (NOT).

19. Method according to Claim 18, **characterized in that** the first pulse signal (P₁) is modulated with regard to the pulse width (PW) for the power control in the normal upper part-load range (NOT).

20. Method according to Claim 18 or 19, **characterized in that** the second pulse signal (P₂) is modulated for controlling the power in the highest upper part-load range (HOT).

21. Method according to one of Claims 18 to 20 **characterized in that** the other pulse signal (P₂, P₁), respectively, is kept constant with regard to its pulse width (PW).

22. Method according to one of Claims 16 to 21, **characterized in that** the third frequency is of the same order of magnitude as the second frequency (f₂).

23. Method according to Claim 22, **characterized in that** the third frequency is substantially identical to the second frequency (f₂).

24. Method according to one of Claims 21 to 23, **characterized in that** the lower part-load range (UT) and the upper part-load range (OT) cover the entire part-load range up to full load.

25. Method according to one of Claims 16 to 24, **characterized in that** the first pulse signal (P₁) and the second pulse signal (P₂) are generated as continuous pulse signal trains (PS) with constant frequency and the control signal in the upper part-load range (OT) is generated from the two pulse signal trains (P₁, P₂) by conducting an OR operation.

## Revendications

1. Circuit de commande pour faire fonctionner, avec commande de la puissance, une charge (14), comprenant un interrupteur à semiconducteurs (12), qui agit dans un circuit de charge (10) et qui, pour commander la puissance de la charge (14), réalise une modulation d'impulsions en durée d'une tension d'alimentation (U_{bar}), et une unité de commande (20) pour l'interrupteur à semiconducteurs (12), qui produit, pour la commande de la puissance aussi bien dans une gamme inférieure de charge partielle (UT) que dans une gamme supérieure de charge partielle (OT) située entre la gamme inférieure de charge partielle (UT) et la pleine charge, un signal de commande impulsionnel (PS), comprenant des signaux de commande impulsionnels (P₁,P₂) qui se succèdent, sont modulés selon une modulation d'impulsions en durée et sont séparés par des pauses entre impulsions, **caractérisé en ce que** l'unité de commande (20) reçoit, par l'intermédiaire d'un signal d'entrée (E), une information indiquant avec quelle puissance la charge (14) doit fonctionner, de sorte que l'unité de commande (20) établit une différenciation indiquant si la puissance, avec laquelle la charge (14) doit fonctionner, se situe dans la gamme inférieure de charge partielle (UT) ou dans la gamme supérieure de charge partielle (OT), que l'unité de commande (20) produit dans la gamme supérieure de charge partielle (OT), en tant que signal de commande impulsionnelle (PS), un premier signal impulsionnel (P₁) comportant des premières impulsions individuelles (PE₁), qui se succèdent continûment avec une première fréquence d'impulsions (f₁), ainsi que pendant les pauses (PP) entre impulsions du premier signal impulsionnel (P₁), un second signal impulsionnel (P₂) comportant des secondes impulsions individuelles (PE₂) qui se succèdent continûment avec une seconde fréquence (f₂), la seconde fréquence (f₂) étant supérieure, au moins d'un facteur 10, à la première fréquence (f₁), et dans la gamme supérieure de charge partielle (OT), au moins l'un des premier et second signaux impulsionnels (P₁,P₂) pouvant être modulés selon une modulation d'impulsions en durée pour la commande de la puissance, et que la commande (20) dans la gamme inférieure de charge partielle (UT) produit en tant que signal de commande impulsionnel (PS) un troisième signal impulsionnel ayant une troisième fréquence, qui est supérieure à la première fréquence (f₁).

2. Circuit de commande selon la revendication 1, **caractérisé en ce que** seul l'un des signaux impulsionnels (P₁,P₂) peut être modulé par une modulation d'impulsions en durée dans la première gamme de charge partielle (OT).

3. Circuit de commande selon la revendication 1 ou 2, **caractérisé en ce que** la gamme supérieure de charge partielle (OT) peut être subdivisée en une gamme supérieure maximale la plus élevée de charge partielle (HOT) et une gamme supérieure normale de charge partielle (NOT) et que dans la gamme supérieure normale de charge partielle (NOT), les impulsions individuelles (PE₁) du premier signal impulsionnel (P₁) peuvent être modulées selon une modulation d'impulsions en durée et que dans la gamme supérieure maximale de charge partielle (HOT), les impulsions individuelles (PE₂) du second signal impulsionnel (P₂) peuvent être modulées selon une modulation d'impulsions en durée.

4. Circuit de commande selon la revendication 3, **caractérisé en ce que** dans la gamme normale supérieure de charge partielle (NOT), la largeur (PW₂) des impulsions individuelles (PE) du second signal impulsionnel (P₂) est constante.

5. Circuit de commande selon la revendication 3 ou 4, **caractérisé en ce que** dans la gamme supérieure maximale de charge partielle (HOT), la largeur (PW₂) des impulsions individuelles (P₂) du premier signal impulsionnel (P₁) est constante.

6. Circuit de commande selon l'une des revendications précédentes, **caractérisé en ce que** la troisième fréquence est du même ordre de grandeur que la seconde fréquence (f₂).

7. Circuit de commande selon la revendication 6, **caractérisé en ce que** la troisième fréquence et la seconde fréquence (f₂) sont approximativement égales.

8. Circuit de commande selon la revendication 7, **caractérisé en ce que** la troisième fréquence est égale à la seconde fréquence (f₂).

9. Circuit de commande selon l'une des revendications précédentes, **caractérisé en ce que** la transition depuis la première gamme de charge partielle (UT) à la gamme supérieure de charge partielle (OT) s'effectue pour des valeurs de charge partielle dans la gamme d'environ 20 % jusqu'à environ 50 %.

10. Circuit de commande selon la revendication 9, **caractérisé en ce que** la transition depuis la première gamme de charge partielle (UT) à la gamme supérieure de charge partielle (OT) s'effectue pour des valeurs de charge partielle dans la gamme d'environ 30 % jusqu'à environ 40 %.

11. Circuit de commande selon l'une des revendications précédentes, **caractérisé en ce que** la seconde fréquence (f₂) et/ou la troisième fréquence est supérieure, d'un facteur de grandeur de l'ordre de 30 ou plus, à la première fréquence (f₁).

12. Circuit de commande selon l'une des revendications précédentes, **caractérisé en ce que** la gamme supérieure de charge partielle (OT) se raccorde directement à la gamme inférieure de charge partielle (UT).

13. Circuit de commande selon l'une des revendications précédentes, **caractérisé en ce que** la gamme inférieure de charge partielle (UT) et la gamme supérieure de charge partielle (OT) couvrent l'ensemble de la gamme de charge partielle jusqu'à la pleine charge.

14. Circuit de commande selon l'une des revendications précédentes, **caractérisé en ce que** la commande (20) comporte un générateur d'impulsions (22) et un étage (24) de mise en forme d'impulsions.

15. Circuit de commande selon l'une des revendications précédentes, **caractérisé en ce que** le premier signal impulsionnel (P₁) et le second signal impulsionnel (P₂) peuvent être produits sous la forme d'impulsions individuelles (P₁, P₂) de signaux impulsionnels comportant des impulsions individuelles (PE₁, PE₂) qui se succèdent continûment, et possédant une fréquence constante (f₁, f₂) et que le signal de commande (S) pour la gamme supérieure de charge partielle (OT) est obtenu par une combinaison OU à partir des trains (P₁, P₂) de signaux impulsionnels.

16. Procédé pour faire fonctionner, avec commande de la puissance, une charge (14) au moyen d'un circuit de commande pour faire fonctionner, avec commande de la puissance, une charge (14), comprenant un interrupteur à semiconducteurs (12), qui agit dans un circuit de charge (10) et qui, pour commander la puissance de la charge (14), réalise une modulation d'impulsions en durée d'une tension d'alimentation (U_{bar}), et une unité de commande (20) pour l'interrupteur à semiconducteurs (12), qui produit, pour la commande de la puissance aussi bien dans une gamme inférieure de charge partielle (UT) que dans une gamme supérieure de charge partielle (OT) située entre la gamme inférieure de charge partielle (UT) et la pleine charge, un signal de commande impulsionnel (PS), comprenant les signaux de commande impulsionnels (P₁,P₂) qui se succèdent, sont modulés selon une modulation d'impulsions en durée, et sont séparés par des pauses entre impulsions,
**caractérisé en ce que** l'unité de commande (20) est informée, au moyen d'un signal d'entrée (E), de la puissance avec laquelle la charge (14) doit fonctionner, que l'unité de commande (20) établit une différenciation indiquant si la puissance, avec laquelle la charge (14) doit fonctionner, se situe dans la gamme inférieure de charge partielle (UT) ou dans la gamme supérieure de charge partielle (OT), que l'unité de commande (20) produit dans la gamme supérieure de charge partielle (OT), en tant que signal de commande impulsionnel (PS), un premier signal impulsionnel (P₁) comportant des premières impulsions individuelles (PE₁), qui se succèdent continûment avec une première fréquence d'impulsions (f₁), ainsi que pendant les pauses (PP) entre impulsions du premier signal impulsionnel (P₁), un second signal impulsionnel (P₂) avec des secondes impulsions individuelles (PE₂) qui se succèdent continûment avec une seconde fréquence (f₂), la seconde fréquence (f₂) étant supérieure, au moins d'un facteur 10, à la première fréquence (f₁), et dans la gamme supérieure de charge partielle (OT), au moins l'un des premier et second signaux impulsionnels (P₁,P₂) pouvant être modulé selon une modulation d'impulsions en durée pour la commande de la puissance, et que l'unité de commande (20) dans la gamme inférieure de charge partielle (UT) produit en tant que signal de commande impulsionnel (PS) un troisième signal impulsionnel ayant une troisième fréquence, qui est supérieure à la première fréquence (f₁).

17. Procédé selon la revendication 16, **caractérisé en ce que** seule la largeur (PW) de l'un des signaux impulsionnels (P₁,P₂) est modulée, alors que l'autre des signaux impulsionnels (P₂,P₁) est maintenu constant.

18. Procédé selon l'une des revendications 16 ou 17, **caractérisé en ce que** la gamme supérieure de charge partielle (OT) est divisée en une gamme supérieure maximale de charge partielle (HOT) et en une gamme supérieure normale de charge partielle (NOT).

19. Procédé selon la revendication 18, **caractérisé en ce que** dans la gamme normale supérieure de charge partielle (NOT), la largeur d'impulsion (PW) du premier signal impulsionnel (P₁) est modulée pour la commande de puissance.

20. Procédé selon la revendication 18 ou 19, **caractérisé en ce que** dans la gamme supérieure maximale de charge partielle (HOT), le second signal impulsionnel (P₂) est modulé pour la commande de la puissance.

21. Procédé selon l'une des revendications 18 à 20, **caractérisé en ce que** la largeur d'impulsion de l'autre signal impulsionnel respectif (P₂, P₁) est maintenue constante.

22. Procédé selon l'une des revendications 16 à 21, **caractérisé en ce que** la troisième fréquence est du même ordre de grandeur que la seconde fréquence (f₂).

23. Procédé selon la revendication 22, **caractérisé en ce que** la troisième fréquence est sensiblement égale à la seconde fréquence (f₂).

24. Procédé selon l'une des revendications 21 à 23, **caractérisé en ce que** la gamme inférieure de charge partielle (UT) et la gamme supérieure de charge partielle (OT) couvrent l'ensemble de la gamme de charge partielle jusqu'à la pleine charge.

25. Procédé selon l'une des revendications 16 à 24, **caractérisé en ce que** le premier signal impulsionnel (P₁) et le second signal impulsionnel (P₂) sont produits sous la forme de trains continus (PS) de signaux impulsionnels avec une fréquence constante et le signal de commande dans la gamme supérieure de charge partielle (OT) est produit au moyen de la combinaison OU à partir des deux trains (P₁,P₂) de signaux impulsionnels.
